Europäisches Patentamt

(19) European Patent Office

Office européen des brevets

(11) Numéro de publication : **0 308 304 B1**

(12) **FASCICULE DE BREVET EUROPEEN**

(45) Date de publication du fascicule du brevet :
07.08.91 Bulletin 91/32

(51) Int. Cl.$^5$ : **H01J 49/16, H01J 37/256,
G01N 23/225**

(21) Numéro de dépôt : 88402279.9

(22) Date de dépôt : 09.09.88

(54) **Procédé d'analyse d'un échantillon par érosion au moyen d'un faisceau de particules, et dispositif pour la mise en oeuvre de ce procédé.**

(30) Priorité : 11.09.87 FR 8712598

(43) Date de publication de la demande :
22.03.89 Bulletin 89/12

(45) Mention de la délivrance du brevet :
07.08.91 Bulletin 91/32

(84) Etats contractants désignés :
DE GB

(56) Documents cités :
US-A- 4 442 354

(73) Titulaire : CAMECA
103, Boulevard Saint-Denis
F-92400 Courbevoie (FR)

Titulaire : IMEC Inter Universitair
Micro-Electronica Centrum
Kapeldreef 75
B-3030 Leuven-Heverlee (BE)

(72) Inventeur : Vandervorst, Wielfried
THOMSON-CSF SCPI 19, avenue de Messine
F-75008 Paris (FR)
Inventeur : Rasser, Bernard
THOMSON-CSF SCPI 19, avenue de Messine
F-75008 Paris (FR)
Inventeur : de Bisschop, Peter
THOMSON-CSF SCPI 19, avenue de Messine
F-75008 Paris (FR)

(74) Mandataire : Sciaux, Edmond et al
THOMSON-CSF SCPI
F-92045 PARIS LA DEFENSE CEDEX 67 (FR)

## Description

L'invention concerne un procédé d'analyse d'un échantillon par érosion au moyen d'un faisceau de particules, et un dispositif pour la mise en oeuvre de ce procédé (voir les préambules des revendications 1 et 4).

On connaît plusieurs procédés d'analyse chimique de solide, mettant en oeuvre une érosion au moyen d'un faisceau de particules. Par exemple, la spectrométrie de masse par ions secondaires consiste à arracher des particules d'un échantillon à analyser, au moyen d'un faisceau d'ions, appelé faisceau primaire, qui balaye la surface de l'échantillon de façon à creuser un cratère ayant un fond plat, et consiste à identifier les matériaux arrachés au fond plat du cratère, par spectrométrie de masse.

Pour réaliser une analyse fiable dans la profondeur d'un échantillon solide il est nécessaire d'obtenir un cratère d'érosion ayant un fond plat, pour constituer une surface d'analyse ayant un niveau bien défini. En général, le faisceau primaire était un faisceau continu. Pour certaines applications particulières, telles que l'analyse de grosses molécules, un faisceau primaire pulsé a été utilisé pour permettre une mesure des spectres de masse par la technique du temps de vol.

Plus récemment de nouveaux procédés ont été utilisés, qui consistent en outre à réaliser une post-ionisation des particules neutres arrachées par le faisceau primaire, au moyen d'un faisceau laser. Ce faisceau laser doit être de puissance relativement élevée, ce qui conduit à utiliser un faisceau laser pulsé. Le faisceau primaire est un faisceau d'ions ou de photons produit par une source continue et ce faisceau est découpé en impulsions en appliquant une tension pulsée à des plaques de déviation placées sur le chemin des particules entre la source et l'échantillon. Les impulsions du faisceau primaire sont synchronisées avec les impulsions du laser de telle façon que les impulsions lasers ionisent les particules neutres arrachées à l'échantillon, tout de suite après qu'elles aient été arrachées par l'impulsion du faisceau primaire.

De tels procédés connus sont décrits par exemple dans les références suivantes :

— Hurst et al., Sputter Initiated Resonance Ionization Spectrometry, US Patent 4,442,354 10 april 1984 ;
— J.E. Parks et al., Thin Solid Films 8 (1983) 69 ;
— F.M. Kimock et al., Anal. Chem. 56 (1984) 2782 ;
— M.J. Pellin et al., Surf. Science 144 (1984) 619 ;
— C. Becker et al., Anal. Chem. 56 (1984) 1671.

La mise en oeuvre de ces procédés connus rencontre deux problèmes.

Un premier problème concerne le temps nécessaire pour réaliser une analyse lorsqu'une certaine quantité de matériau de l'échantillon doit être arrachée, par exemple pour réaliser une mesure du profil en profondeur de la concentration de certaines impuretés dans un échantillon. En effet, il y a incompatibilité entre l'efficacité de l'analyse et la rapidité d'exécution de cette analyse. La post-ionisation des particules neutres arrachées à l'échantillon est réalisée au moyen d'un faisceau laser pulsé, car elle nécessite un laser de puissance relativement grande et un tel laser est en général un laser pulsé. La fréquence des impulsions des lasers de puissance est comprise entre 10 et 200 Hz. Les particules arrachées par le faisceau primaire dans l'intervalle de temps séparant deux impulsions lasers consécutives ne sont évidemment pas ionisées et donc ne sont pas détectées. Dans les cas où il est nécessaire d'avoir une grande efficacité de la détection, une telle perte d'informations est difficilement acceptable. C'est pourquoi le faisceau primaire est pulsé, en synchronisme avec le faisceau laser.

Pour avoir le maximum d'efficacité de la détection, il faudrait qu'il n'y ait qu'une seule impulsion du faisceau primaire avant chaque impulsion laser. Ceci conduirait à une grande lenteur de l'analyse. Par exemple, si le faisceau primaire avait des impulsions d'une durée de 1 microseconde et une fréquence de 100 Hz, son rapport cyclique serait de $10^{-4}$. La vitesse de l'analyse étant directement proportionnelle à la vitesse de l'érosion, la vitesse de l'analyse dans cet exemple serait donc inférieur de plusieurs ordres de grandeur à la vitesse obtenue dans la technique de spectrométrie de masse par ions secondaires sans post-ionisation, utilisant un faisceau primaire continu. La mesure d'un profil de concentration jusqu'à une profondeur d'un micron prendrait de nombreuses heures. Une telle durée est inacceptable.

Pour réduire la durée de l'analyse, un procédé connu consiste à utiliser un faisceau primaire continu pour éroder la surface de l'échantillon jusqu'à une certaine profondeur, sans chercher à réaliser des mesures de concentration. Puis il consiste à découper le faisceau primaire en impulsions, synchrones avec les impulsions du faisceau laser de post-ionisation, lorsque la profondeur choisie est atteinte, afin de faire une mesure de concentration à cette profondeur. Ensuite, de nouveau un faisceau primaire continu est utilisé pour éroder l'échantillon jusqu'à un prochain palier de profondeur où une nouvelle mesure est à réaliser. Ainsi de palier en palier, ce procédé permet de mesurer un profil en profondeur de la concentration des impuretés, en minimisant la durée de l'analyse, mais il est clair que cette mesure du profil ne fournit aucune information entre chaque palier de profondeur.

Le but de l'invention est de proposer un procédé d'analyse permettant de minimiser la durée de l'analyse sans perdre une quantité importante d'informations.

Un second problème concerne la réalisation du dispositif d'analyse, car celui-ci doit comporter un dispositif de découpage du faisceau primaire ayant les performances suivantes :

— il doit permettre d'obtenir une forme d'impulsion quelconque et l'impulsion doit pouvoir être dirigée vers n'importe quel point de la surface de l'échantillon ;

— la surface d'impact du faisceau primaire doit garder la même position sur l'échantillon lorsque le faisceau est allumé et lorsqu'il est en cours d'extinction, c'est-à-dire qu'il ne doit pas subir de mouvements de translation à la surface de l'échantillon, sous l'action des impulsions de tension commandant la déflection du faisceau pour l'allumer ou pour l'éteindre ;

— le courant du faisceau primaire arrivant sur l'échantillon doit être rigoureusement nul entre les impulsions du faisceau primaire, c'est-à-dire qu'il doit être parfaitement éteint.

Un second but de l'invention est donc de proposer un dispositif d'analyse mettant en oeuvre le procédé selon l'invention, tout en procurant les performances ci-dessus.

Le procédé selon l'invention consiste essentiellement à éroder le fond du cratère, qui constitue la surface d'analyse proprement dite, juste avant chaque impulsion laser ; et à éroder les flancs du cratère, qui ne constitue pas la surface d'analyse proprement dite mais qui doit être érodé pour qu'il existe un cratère, pendant le reste du temps entre deux impulsions lasers consécutives.

Selon l'invention, un procédé d'analyse d'un échantillon par érosion au moyen d'un faisceau de particules pulsé dit faisceau primaire, consistant à :

— dévier le faisceau primaire qui est éteint pendant les déplacements de façon que son centre balaye virtuellement l'échantillon sur une surface dite surface de balayage pour creuser un cratère à fond plat, ce fond plat constituant une surface dite d'analyse ;

— ioniser, au moyen d'un faisceau laser pulsé, synchronisé avec le faisceau primaire, des particules arrachées à la surface d'analyse ;

— identifier, au moyen d'un spectromètre de masse, la nature des particules arrachées à l'échantillon et ionisées ;

est caractérisé en ce que la fréquence des impulsions du faisceau primaire est supérieure à la fréquence des impulsions du faisceau laser ; et en ce qu'il consiste à dévier le faisceau primaire de telle façon que son centre balaye une partie de la surface de balayage située hors de la surface d'analyse, pendant une majeure partie des intervalles de temps séparant les impulsions du faisceau laser ; et qu'il balaye la surface d'analyse, pendant une durée correspondant à une impulsion du faisceau primaire, juste avant chaque impulsion du faisceau laser.

L'invention sera mieux comprise et d'autres détails apparaîtront à l'aide de la description ci-dessous et des figures l'accompagnant :

— La figure 1 représente schématiquement une coupe d'un cratère obtenu dans un exemple de mise en oeuvre du procédé selon l'invention, ainsi que la surface de balayage et la surface d'analyse correspondant à ce cratère ;

— la figure 2 représente le balayage réalisé avec les impulsions du faisceau primaire pour creuser ce cratère conformément au procédé selon l'invention ;

— la figure 3 représente un chronogramme des impulsions lasers et des impulsions du faisceau primaire dans un exemple de mise en oeuvre du procédé selon l'invention ;

— la figure 4 représente schématiquement un exemple de réalisation du dispositif selon l'invention ;

— la figure 5 représente schématiquement, avec plus de détails, l'exemple de réalisation représenté sur la figure 3 ;

— la figure 6 représente des chronogrammes illustrant les signaux de commande de cet exemple de réalisation.

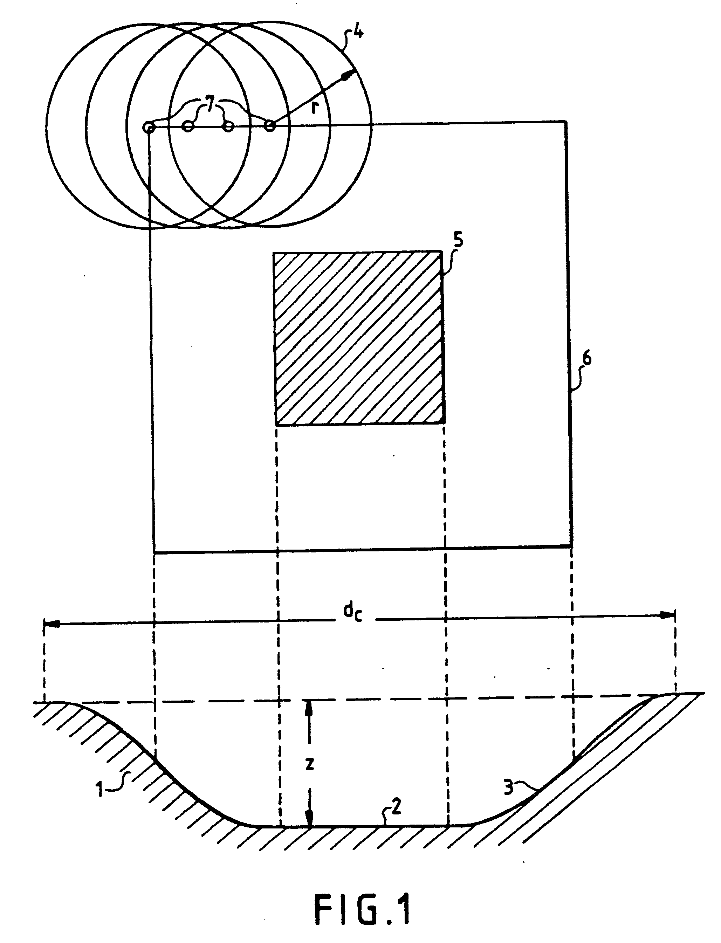

Sur la figure 1, l'échantillon 1 subit une érosion qui creuse un cratère comportant un fond plat 2 et des parois inclinées 3. La surface d'analyse proprement dite est constituée seulement par le fond plat 2 car il est situé à une profondeur constante $z$. Les parois inclinées 3 sont inévitables lors du creusement par érosion, mais ne peuvent pas constituer une surface d'analyse puisqu'elles correspondent à une profondeur variable à l'intérieur de l'échantillon 1. Pour que l'analyse soit fiable, il est nécessaire que le fond 2 du cratère reste parfaitement plat au fur et à mesure du creusement du cratère. Pour cela, il faut éroder simultanément les parois 3 et le fond 2.

Dans cet exemple de mise en oeuvre, le cratère est supposé avoir une forme approximativement carrée, en vue de dessus, et la surface d'impact, 4, du faisceau primaire, est supposée avoir une section circulaire de rayon $r$. La position de chaque impulsion du faisceau primaire est repérée par la position du centre 7 de sa zone d'impact 4. Les centres 7 des zones d'impact du faisceau primaire sont tous situés à l'intérieur d'une zone carrée 6 appelée surface de balayage. Cette dernière définit la largeur totale $d_c$ du cratère qui est érodé dans l'échantillon. La surface totale qui est érodée est donc un carré ayant une aire $d_c \times d_c$ dont les limites sont imprécises. Cette aire est évidemment supérieure à l'aire de la surface de balayage 6. Les centres 7 des zones d'impact 4 qui érodent le fond plat 2 sont situés à l'intérieur d'une zone carrée 5, appelée surface d'analyse, qui a une aire $S_a$ très inférieure à l'aire $S_e$ de la surface de balayage 6.

Dans d'autres exemples de mise en oeuvre, le cratère peut avoir une forme autre que celle d'un carré, par exemple une forme rectangulaire ou une forme circulaire.

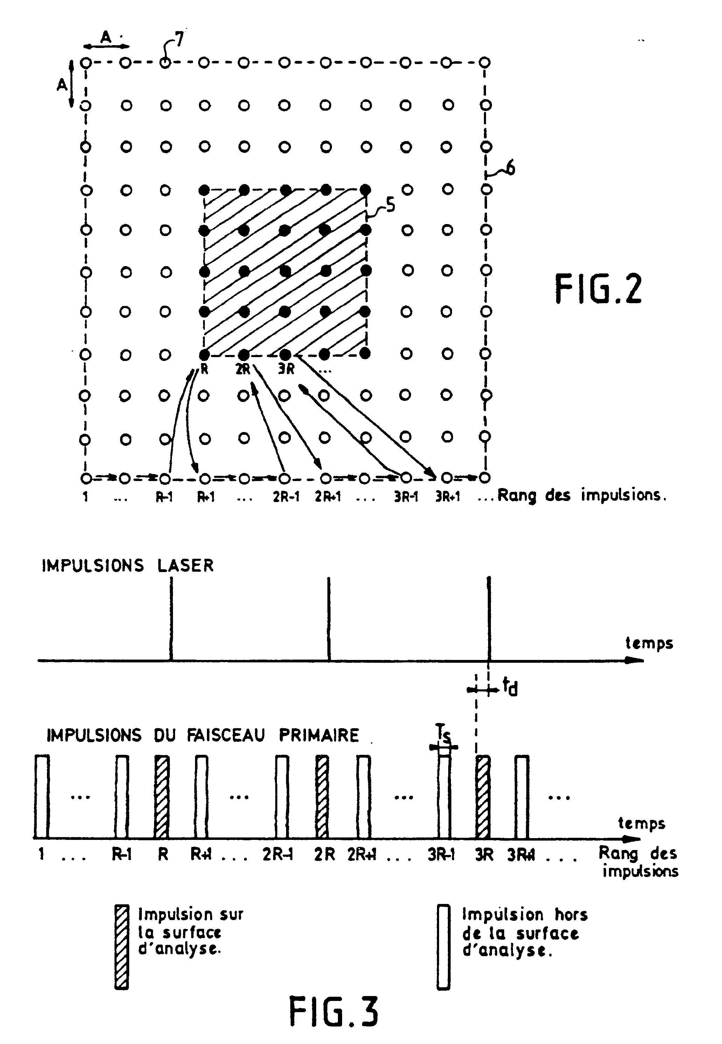

La figure 2 représente le balayage virtuel réalisé avec le faisceau primaire, conformément au procédé selon l'invention, pour creuser ce cratère. Elle représente par des ronds blancs les centres 7 des zones d'impact 4 situés dans la surface 6 mais hors de la surface d'analyse 5, et représente par des ronds noirs les centres 7 des zones d'impact 4 situés dans la surface d'analyse 5. La zone d'analyse 5 est hachurée. Le balayage est dit virtuel car le faisceau est éteint pendant les déplacements. Les centres des zones d'impact 4 sont répartis régulièrement sur la surface de balayage 6 en étant séparés par des distances A, horizontalement et verticalement. La distance A est suffisamment petite devant le rayon, r, de chaque zone d'impact pour que le recouvrement des zones d'impact 4 assure une érosion homogène en surface. Le rapport R entre le nombre d'impulsions du faisceau primaire dont le centre tombe dans la zone de balayage 6 et le nombre total d'impulsions du faisceau primaire dont le centre tombe dans la zone d'analyse 5 est égal à : $R = S_s/S_a$.

Pour obtenir le maximum d'informations sur la composition de la surface d'analyse 5, aucune impulsion du faisceau primaire ne doit être envoyée sur la surface d'analyse tant que le laser n'est pas prêt à envoyer une impulsion laser immédiatement après. Dans ces conditions, la vitesse maximale d'érosion est obtenue si la fréquence des impulsions du faisceau primaire envoyées sur la surface d'analyse est égale exactement à la fréquence des impulsions lasers. La fréquence des impulsions d'un laser de puissance étant relativement basse, au mieux quelques kilohertz, l'intervalle de temps séparant deux impulsions lasers consécutives est suffisamment long pour permettre l'envoi d'impulsions supplémentaires du faisceau primaire. Ces impulsions supplémentaires sont dirigées de telle façon que le centre 7 de la zone d'impact 4 tombe dans la partie périphérique de la surface de balayage 6, hors de la surface d'analyse 5. Elles permettent d'éroder les parois du cratère, ce qui est nécessaire pour approfondir ensuite le fond plat de ce cratère.

Par conséquent, les impulsions du faisceau primaire sont envoyées avec une fréquence constante qui est R fois plus grande que la fréquence des impulsions lasers. Le chemin suivi par le balayage du faisceau primaire est tel que le centre du faisceau primaire balaye virtuellement la surface de balayage 6, hors de la surface d'analyse 5, pour R-1 impulsions, puis entre dans la zone d'analyse 5 pour la $R^{ième}$ impulsion du faisceau primaire, puis revient hors de la zone d'analyse 5 pour la $(R + 1)^{ième}$ impulsion jusqu'au à la $(2R - 1)^{ième}$ impulsion, puis retourne dans la zone d'analyse 5 pour la $2R^{ième}$ impulsion, puis revient hors de la zone d'analyse 5 pour la $(2R +$

$1)^{ième}$ impulsion jusqu'à la $(3R - 1)^{ième}$ impulsion, puis va dans la zone d'analyse 5 pour la $3R^{ième}$ impulsion, puis revient hors de la zone d'analyse 5 pour la $(3R + 1)^{ième}$ impulsion, etc..., jusqu'à la fin du balayage de la surface de balayage 6. Puis le chemin du balayage est parcouru à nouveau. Le nombre d'étapes du balayage est fixé à 256 × 256, par exemple. L'utilisateur choisit le rapport R en fonction de la plus petite concentration qu'il doit mesurer et en fonction de la profondeur maximale à atteindre.

La figure 3 représente un chronogramme des impulsions lasers et des impulsions du faisceau primaire, pour creuser cet exemple de cratère. Les impulsions du faisceau primaire, dont le centre tombe sur la surface d'analyse 5, sont hachurées alors que les impulsions, du faisceau primaire, dont le centre tombe hors de la surface d'analyse 5 sont blanches. Ce chronogramme met en évidence qu'une impulsion laser est envoyée après chaque $R^{ième}$ impulsion du faisceau primaire, avec un retard $t_d$ par rapport au début de l'impulsion du faisceau primaire.

Il est possible de démontrer que la vitesse d'érosion, exprimée en microns par minute, est proportionnelle à l'intensité $I_p$ du faisceau primaire, à la durée $T_p$ des impulsions du faisceau primaire, à la fréquence f des impulsions lasers ; et inversement proportionnelle à l'aire $S_a$ de la surface d'analyse 5. L'intensité $I_p$ et la fréquence f sont limitées par des considérations pratiques et l'aire $S_a$ a une valeur fixée. Pour augmenter la vitesse d'érosion, l'utilisateur a la possibilité d'agir sur la durée $T_p$ des impulsions du faisceau primaire, mais alors les concentrations minimales mesurables augmentent, autrement dit la sensibilité décroît. En outre, il est nécessaire de réserver un certain temps pour le déplacement du faisceau primaire, le faisceau primaire devant obligatoirement être éteint pendant son déplacement pour éviter de créer une érosion irrégulière et de fausser les mesures.

Le dispositif de découpage du faisceau primaire doit donc interrompre parfaitement le faisceau avant son déplacement et ne l'allumer de nouveau que lorsqu'il a atteint, de manière virtuelle, la position prédéterminée pour sa surface d'impact. Pendant le temps où le faisceau primaire est allumé, le dispositif de découpage ne doit pas non plus provoquer le moindre déplacement de la zone d'impact.

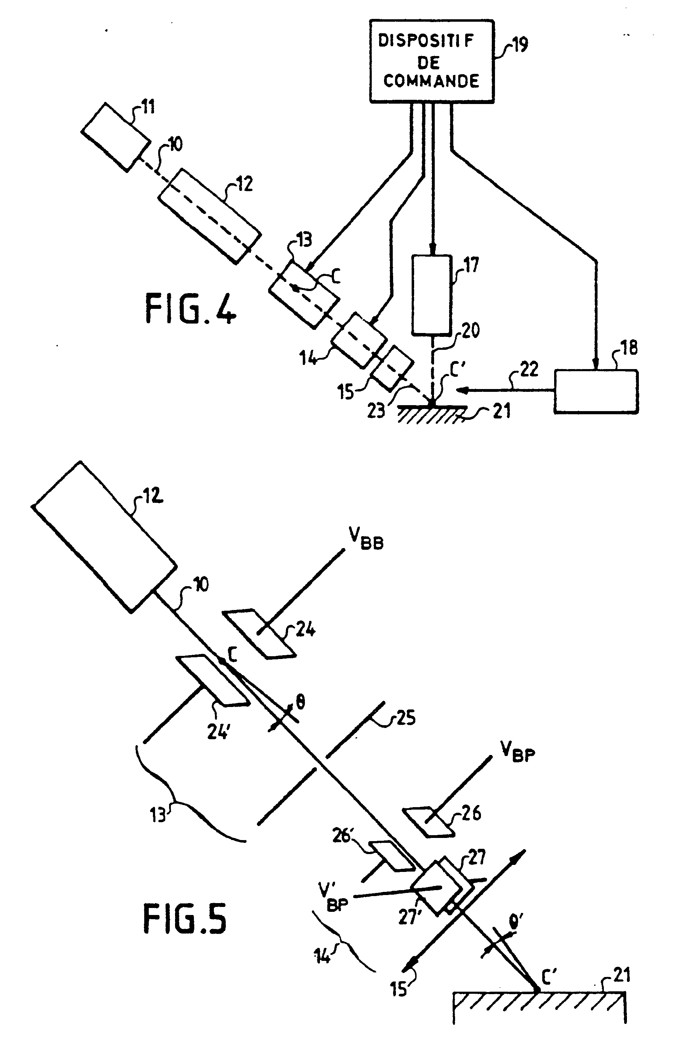

La figure 4 représente schématiquement un exemple de réalisation du dispositif selon l'invention pour la mise en oeuvre du procédé selon l'invention. Cet exemple de réalisation comporte : une source d'ions, 11 ; un dispositif de transfert de faisceaux, 12; un dispositif 13 de découpage de faisceau ; un dispositif 14 de positionnement de faisceau ; un dispositif 15 de transfert de faisceaux ; un spectromètre de masse 17 ; un laser 18 ; et un dispositif de commande 19.

Le faisceau primaire 10 est constitué, par exemple, d'ions d'un gaz rare (Argon ou Xénon) ou d'autres éléments (Gallium, Indium) et sa source est constituée, par exemple, par un duo-plasmatron ou par une source de métal liquide, fournissant un courant typique de quelques micro-ampères. Les ions sont ensuite accélérés à une énergie de quelques kilo-électrons-volts.

Le dispositif 12 de transfert de faisceau comporte au moins quelques éléments de focalisation, mais peut comporter en outre un aimant, une ouverture de sélection de masse, et au moins un déviateur électrostatique.

Le dispositif 12 doit créer une pupille C dans la ligne de transfert du faisceau, à une position correspondant au centre du dispositif 13 de découpage du faisceau. Le dispositif 13 autorise le passage du faisceau primaire vers un échantillon 21, seulement à certains instants bien définis, sous la commande du dispositif de commande 19. Les impulsions du faisceau primaire sortant du dispositif 13 sont ensuite mises en forme et positionnées sur l'échantillon 21, par le dispositif 15 de transfert de faisceau et par le dispositif 14 de positionnement de faisceau. Le dispositif 15 peut comporter, par exemple, une ou plusieurs lentilles, des ouvertures, des stigmateurs, et des déviateurs. La pupille réelle C, produite par le dispositif 12 de transfert de faisceau, a une image C' qui est formée à la surface de l'échantillon 21.

Les particules 20 de matériau arraché à l'échantillon 21 sont ionisées par un faisceau laser 22, pulsé, fourni par le laser 18 sous la commande du dispositif 19, puis sont identifiés par le spectromètre de masse 17 qui est lui aussi commandé par le dispositif 19.

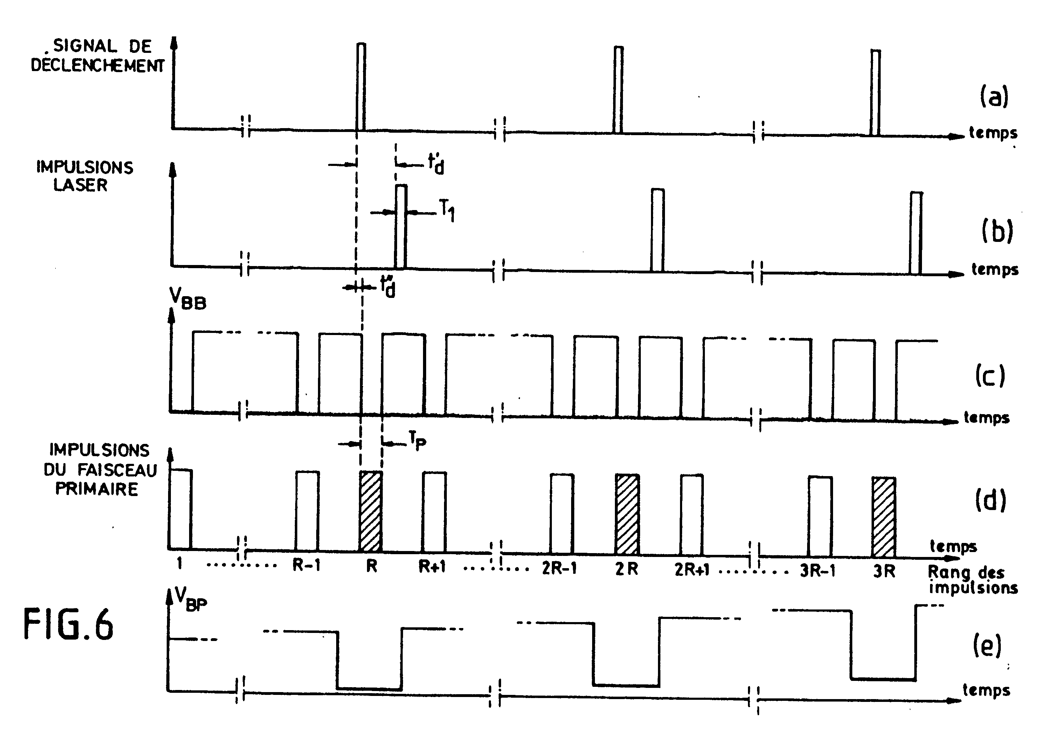

La figure 5 représente d'une manière plus détaillée le dispositif 13 de découpage du faisceau primaire 10, le dispositif 14 de positionnement de ce faisceau et le dispositif 15 de transfert de faisceau, dans un exemple de réalisation. Le dispositif 13 comporte deux plaques de déviation électrostatique, 24 et 24', placées de part et d'autre de la pupille C du faisceau 10 ; et comporte un diaphragme 25, en aval sur le chemin du faisceau 10. Les plaques 24 et 24' reçoivent une différence de potentiel $V_{BB}$ qui provoque une déviation angulaire θ. Cette déviation provoque une variation θ' de l'angle d'incidence du faisceau 10 à la surface de l'échantillon 21. Comme il a été mentionné précédemment, l'image C' du point C est formée à la surface de l'échantillon 21, par conséquent cette variation θ' de l'angle d'incidence n'est accompagnée d'aucun déplacement de la zone d'impact du faisceau à la surface de l'échantillon 21. Lorsque la différence de potentiel $V_{BB}$ est suffisante, l'angle θ est suffisant pour que le faisceau 10 soit intercepté par le diaphragme 25. Le faisceau est alors éteint au point C' sans aucun déplacement indésirable. De manière analogue, le faisceau 10 peut être rallumé au point C' sans aucun déplacement.

Le dispositif 14 de positionnement du faisceau permet, entre temps, de déplacer le point C' où se forme l'image du point C. Le dispositif 14 comporte une première paire de plaques de déviation électrostatique, 26 et 26', et une seconde paire de plaques de déviation électrostatique, 27 et 27'. La première et la seconde paire de plaques reçoivent respectivement des différences de potentiel $V_{BP}$ et $V'_{BP}$ pour positionner le faisceau en réalisant le balayage décrit précédemment. Les deux paires de plaques ont des plans de symétrie orthogonaux, de manière à réaliser un positionnement selon deux dimensions. Les différences de potentiel $V_{BP}$, $V'_{BP}$ et $V_{BB}$ sont fournies par le dispositif de commande 19. Le dispositif 15 est constitué par une simple lentille dans cet exemple. Dans d'autres exemples de réalisation, le dispositif 14 peut comporter un double déviateur, chaque déviateur comportant deux paires de plaques, situées à une même distance de l'échantillon et orthogonales entre elles.

La figure 6 représente des chronogrammes des signaux de commande fournis par le dispositif de commande 19 dans cet exemple de réalisation. Un signal d'horloge, de fréquence f, déclenche les impulsions lasers, avec un retard $t'_d$. Dans cet exemple, le faisceau est transmis par le dispositif de découpage 13 lorsque la différence de potentiel $V_{BB}$ est basse, et il est arrêté lorsque la différence de potentiel $V_{BB}$ est haute. Cette tension est périodique, avec une fréquence f.R. Elle est synchronisée par le signal de déclenchement. Chaque R[ième] passage de $V_{BB}$ du niveau bas a un retard fixé, $t''_d$, par rapport au signal de déclenchement. Chaque passage de $V_{BB}$ au niveau bas allume le faisceau primaire pendant une durée $T_p$ fixée.

Chaque R[ième] impulsion du faisceau primaire est envoyée sur la surface d'analyse alors que les autres impulsions du faisceau primaire sont envoyées hors de la surface d'analyse. Celles qui sont envoyées sur la surface d'analyse sont représentées par des hachures alors que les autres sont représentées en blanc.

La figure 6 représente un chronogramme de la différence de potentiel $V_{BP}$. Le chronogramme de la différence de potentiel $V'_{BP}$ n'est pas représenté car il est semblable. Ce chronogramme de $V_{BP}$ montre qu'après chaque impulsion du faisceau primaire, la différence de potentiel $V_{BP}$ est modifiée pour envoyer la prochaine impulsion du faisceau primaire vers une nouvelle position. Pour les impulsions de rang 1 à R − 1, de rang R + 1 à 2R − 1, et de rang 2R + 1 à 3R − 1, la différence de potentiel $V_{BP}$ a des valeurs élevées correspondant à une zone de balayage située hors de la surface d'analyse 5. Pour les impulsions de rang R, 2R, 3R,..., la différence de potentiel $V_{BP}$ a des valeurs basses qui correspondent à un balayage à l'intérieur de la zone d'analyse 6.

La réalisation d'un dispositif 19 produisant de tels signaux de commande est à la portée de l'Homme de l'Art. Les tensions $V_{BP}$ et $V'_{BP}$ ont des formes particulières qui peuvent être stockées dans une mémoire, chacune sous la forme d'une suite de valeurs numériques. Ces valeurs sont lues séquentiellement et transformées en une différence de potentiel par un convertisseur numérique-analogique. Deux suites de valeurs différentes sont stockées pour chaque valeur entière du rapport R, car l'utilisateur fait varier la valeur de R en fonction de la sensibilité souhaitée et en fonction de la profondeur maximale à atteindre.

**Revendications**

1. Procédé d'analyse d'un échantillon (21) par érosion au moyen d'un faisceau de particules pulsé (23) dit faisceau primaire, consistant à :
— dévier le faisceau primaire (23) qui est éteint pendant les déplacements de façon que son centre (7) balaye virtuellement l'échantillon (21) sur une surface dite surface de balayage (6) pour creuser un cratère à fond plat (2), ce fond plat (2) constituant une surface dite d'analyse (5) ;
— ioniser, au moyen d'un faisceau laser (22) pulsé, synchronisé avec le faisceau primaire (23), des particules arrachées à la surface d'analyse (5) ;
— identifier, au moyen d'un spectromètre de masse (17), la nature des particules arrachées à l'échantillon (21) et ionisées ;
caractérisé en ce que la fréquence des impulsions du faisceau primaire (23) est supérieure à la fréquence des impulsions du faisceau laser (22) ; et en ce qu'il consiste à dévier le faisceau primaire (23) de telle façon que son centre (7) balaye une partie de la surface de balayage (6) située hors de la surface d'analyse (5), pendant une majeure partie des intervalles de temps séparant les impulsions du faisceau laser (22) ; et qu'il balaye la surface d'analyse (5), pendant une durée correspondant à une impulsion du faisceau primaire (23), juste avant chaque impulsion du faisceau laser (22).

2. Procédé selon la revendication 1, caractérisé en ce qu'il consiste à produire les impulsions du faisceau primaire (23) avec une fréquence constante R fois plus élevée que la fréquence des impulsions du faisceau laser (22), R étant un nombre entier supérieur à 1 et égal au rapport entre l'aire souhaitée pour la surface de balayage (6) et l'aire souhaitée pour la surface d'analyse (5).

3. Procédé selon la revendication 1, caractérisé en ce que, pour balayer virtuellement l'échantillon (21) il consiste à déplacer virtuellement le faisceau primaire (23) après l'avoir éteint et à l'allumer après immobilisation à sa nouvelle position ; et en ce que pour produire les impulsions du faisceau primaire (23), il consiste à découper un faisceau continu (10).

4. Dispositif d'analyse, pour la mise en oeuvre du procédé selon la revendication 1, caractérisé en ce qu'il comporte :
— des moyens (11, 12, 13) pour projeter un faisceau pulsé de particules (23), dit faisceau primaire, sur un échantillon à analyser (21) afin d'arracher des particules (20) de cet échantillon ;
— des moyens (14) pour dévier le faisceau primaire (23) en fonction d'un signal de commande;
— un laser (18) pour projeter un faisceau laser pulsé (22), pour ioniser des particules (20) arrachées à l'échantillon (21) ;
— un spectromètre de masse (17) pour identifier les particules (20) arrachées à l'échantillon (21) et ionisées ;
— des moyens de commande (19) pour :
— — commander les moyens de déviation (14) de telle façon que le centre (7) du faisceau primaire (23) qui est éteint pendant les déplacements balaye virtuellement sur l'échantillon (21) une surface dite surface de balayage (6), pour creuser un cratère à fond plat, ce fond plat constituant une surface dite d'analyse (5);
— — commander les moyens (11 à 13) projetant le faisceau primaire (23) pour envoyer ses impulsions avec une fréquence supérieure à celle des impulsions du faisceau laser (22) et en synchronisme avec ces dernières, de façon à envoyer une impulsion du faisceau primaire (23) juste avant chaque impulsion du faisceau laser (22) ;
— — commander les moyens de déviation (15) de telle façon que le centre (7) du faisceau primaire (23) balaye virtuellement une partie de la surface de balayage (6), située hors de la surface d'analyse (5), pendant une majeure partie des intervalles de temps séparant les impulsions du faisceau laser (22), et qu'il balaye virtuellement la surface d'analyse (5) pendant une durée correspondant à une impulsion du faisceau primaire (23), juste avant chaque impulsion du faisceau laser (22).

5. Dispositif selon la revendication 4, caractérisé en ce que les moyens pour projeter un faisceau pulsé de particules comportent :
— une source (11) fournissant un faisceau continu (10) de particules ;
— une paire de plaques (24, 24') de déviation électrostatique, pour dévier le faisceau continu (10) de particules autour d'une pupille (C) de ce faisceau ;
— un diaphragme (25) pour intercepter toutes les particules du faisceau continu (10) lorsqu'elles sont déviées au-delà d'un angle fixé ;
— des moyens (15) de transfert d'un faisceau, pour former l'image (C') de la pupille (C) sur l'échantillon (21).

**Patentansprüche**

1. Verfahren zur Analyse eines Probekörpers (21) durch die Erosion mittels eines Primärstrahl genannten gepulsten Teilchenstrahls (23), umfassend :
— die Ablenkung des Primärstrahls (23), der während der Verschiebungen ausgeschaltet ist, derart, daß sein Zentrum (7) den Probekörper (21) auf einer Abtastoberfläche (6) genannten Oberfläche virtuell abtastet, um einen Rrater mit ebenem Boden (2) auszuhöhlen, wobei dieser ebene Boden (2) eine Analyseoberfläche genannte Oberfläche darstellt ;
— die Ionisierung von aus der Analyseoberfläche (5) herausgeschlagenen Teilchen mittels eines gepulsten Laserstrahls (22), der mit dem Primärstrahl (23) synchronisiert ist ;
— die Identifizierung der aus dem Probekörper (21) herausgeschlagenen und ionisierten Teilchen mittels eines Massenspektrometers (17) ; dadurch gekennzeichnet, daß die Frequenz der Impulse des Primärstrahls (23) oberhalb der Frequenz der Impulse des Laserstrahls (22) liegt und daß es die Ablenkung des Primärstrahls (23) umfaßt, derart, daß dessen Zentrum (7) einen oberhalb der Analyseoberfläche (5) befindlichen Teil der Abtastoberfläche (6) während eines größeren Teils der die Impulse des Laserstrahls (22) trennenden Zeitintervalle abtastet, und daß er die Analyseoberfläche (5) während einer einem Impuls des Primärstrahls (23) entsprechenden Dauer direkt vor jedem Impuls des Laserstrahls (22) abtastet.

2. Verfahren gemäß Anspruch 1, dadurch gekennzeichnet, daß es die Erzeugung der Impulse des Primärstrahls (23) mit einer konstanten Frequenz, die R mal höher als die Frequenz der Impulse des Laserstrahls (22) ist, umfaßt, wobei R eine ganze Zahl größer als 1 und gleich dem Verhältnis zwischen der für die Abtastoberfläche (6) gewünschten Fläche und der für die Analyseoberfläche (5) gewünschten Fläche ist.

3. Verfahren gemäß Anspruch 1, dadurch gekennzeichnet, daß es zum virtuellen Abtasten des Probekörpers (21) die virtuelle Verschiebung des Primärstrahls (23) nach dessen Ausschalten und sein Einschalten nach dem Feststellen in seiner neuen Position umfaßt und daß es für die Erzeugung der Impulse des Primärstrahls (23) die Zerhackung eines kontinuierlichen Strahls (10) aufweist.

4. Analysevorrichtung für die Ausführung des Verfahrens gemäß Anspruch 1, dadurch gekennzeichnet, daß sie umfaßt :
— Mittel (11, 12, 13) zum Projizieren eines Primärstrahl genannten gepulsten Teilchenstrahls (23) auf einen zu analysierenden Probekörper (21), um aus diesem Probekörper Teilchen (20) herauszuschlagen ;

— Mittel (14) zum Ablenken des Primärstrahls (23) in Abhängigkeit von einem Steuersignal ;
— einen Laser (18) zum Projizieren eines gepulsten Laserstrahls (22) zum Ionisieren der aus dem Probekörper (21) herausgeschlagenen Teilchen (20) ;
— ein Massenspektrometer (17) zum Identifizieren der aus dem Probekörper herausgeschlagenen und ionisierten Teilchen (20) ;
— Steuermittel (19) zum :
– – Steuern der Ablenkungsmittel (14), derart, daß das Zentrum (7) des Primärstrahls (23), der während der Verschiebungen ausgeschaltet ist, auf dem Probekörper (21) eine Abtastoberfläche (6) genannte Oberfläche virtuell abtastet, um einen Krater mit ebenem Boden auszuhöhlen, wobei der ebene Boden eine Analyseoberfläche (5) genannte Oberfläche darstellt ;
– – Steuern der Mittel (11 bis 13), die den Primärstrahl (23) projizieren, um dessen Impulse mit einer Frequenz, die oberhalb derjenigen der Impulse des Laserstrahls (22) liegt, und synchron mit diesen letzteren auszusenden, derart, daß ein Impuls des Primärstrahls (23) direkt vor jedem Impuls des Laserstrahls (22) ausgesandt wird ;
– – Steuern der Ablenkungsmittel (15), derart, daß das Zentrum (7) des Primärstrahls (23) einen oberhalb der Analyseoberfläche (5) befindlichen Teil der Abtastoberfläche (6) während eines größeren Teils der die Impulse des Laserstrahls (22) trennenden Zeitintervalle virtuell abtastet und daß es die Analyseoberfläche (5) während einer einem Impuls des Primärstrahls (23) entsprechenden Dauer direkt vor jedem Impuls des Laserstrahls (22) virtuell abtastet.

5. Vorrichtung gemäß Anspruch 4, dadurch gekennzeichnet, daß die Mittel zum Projizieren eines gepulsten Teilchenstrahls umfassen :
— eine einen kontinuierlichen Teilchenstrahl (10) liefernde Quelle (11) ;
— ein Paar von elektrostatischen Ablenkplatten (24, 24'), um den kontinuierlichen Teilchenstrahl (10) um eine Pupille (C) dieses Strahls abzulenken ;
— eine Blende (25) zum Auffangen sämtlicher Teilchen des kontinuierlichen Strahls (10), falls diese über einen festen Winkel hinaus abgelenkt werden ;
— Mittel (15) zum Übertragen eines Strahls, um auf dem Probekörper (1) das Bild (C') der Pupille (C) abzubilden.

## Claims

1. A method for the analysis of a sample (21) by erosion by the intermediary of pulse beam (23) of particles as a primary beam, consisting of :
— deflecting the primary beam (23), which is extinguished during the displacements, in such a manner that its center (7) virtually sweeps the sample (21) on a surface as the sweep surface (6) in order to dig out a crater with a flat bottom (2), said flat bottom (2) constituting a surface to be analyzed (5) ;
— ionizing, with the aid of a pulsed laser beam (22), which is synchronized with the primary beam (23), particles detached from the surface to be analyzed (5) ;
— identifying, by means of a mass spectrometer (17), the nature of the ionized particles detached from the sample (21) ;
characterized in that the frequency of the pulses of the primary beam (23) is greater than the frequency of the pulses of the laser beam (22) ; and in that it consists of deflecting the primary beam (23) in such a manner that its center (7) sweeps a part of the sweep surface (6) positioned clear of the surface to be analyzed, during a major part of the time intervals separating the pulses of the laser beam (22) ; and in that it sweeps the surface to be analyzed (5), during a time corresponding to one pulse of the primary beam (23), just prior to each pulse of the laser beam (22).

2. The method as claimed in claim 1, characterized in that it consists of producing the pulses of the primary beam (23) with a constant frequency R times higher than the frequency of the pulses of the laser beam (22), R being a whole number greater than unity and equal to the ratio between the area desired for the sweep surface (6) and the area desired for the surface to be analyzed (5).

3. The method as claimed in claim 1, characterized in that, in order to virtually sweep the sample (21) it consists of virtually displacing the primary beam (23) after having extinguished it and turning it on again after having halted in a new position thereof ; and in that in order to produce the pulses of the primary beam (23), it consists of cutting up a continuous beam (10).

4. An analysis apparatus for performing the method as claimed in claim 1, characterized in that it comprises :
— means (11, 12 and 13) in order to project a pulsed beam (23) of particles as a primary beam onto a sample (21) to be analyzed in order to detach particles (20) from the sample ;
— means (14) in order to deflect the primary beam (23) as a function of a drive signal ;
— a laser (18) in order to project a pulsed laser beam (22) in order to ionize particles (20) detached from the sample (21) ;
— a mass spectrometer (17) in order to identify the ionized particles (20) detached from the sample (21) ;
— and control means (19) in order to :
— — drive the deflecting means (14) in such a manner that the center (7) of the primary beam (23), which is extinguished during the displacements, virtually sweeps the sample (21) over a sweep area (6) thereof in order to dig out a crater with a flat bottom, said flat bottom constituting a surface to be analyzed ;
— — drive means (111 through 13) projecting the primary beam (7) in order to transmit its pulses with a frequency greater than that of the pulses of the laser beam (22) and synchronously with the same in such a manner as to transmit a pulse of the primary beam (23) just prior to each pulse of the laser beam (22) and ;
— — drive the deflecting means (15) in such a manner that the center of the primary beam (7) virtually sweeps a part of the sweep surface (6) positioned clear of the surface to be analyzed (5) during a major part of the time intervals between the pulses of the laser beam (22), and so that it virtually sweeps the surface to be analyzed (5) during a time corresponding to one pulse of the primary beam (23) just prior to the each pulse of the laser beam (22).

5. The apparatus as claimed in claim 4, characterized in that the means for projecting the pulsed beam of particles comprise :
— a source (11) supplying a continuous beam (10) of particles ;
— a pair of electrostatic deflecting plates (24 and 24') in order to deflect the continuous beam (10) of particles around a pupil (C) of the said beam,
— a diaphragm (25) in order to intercept all the particles of the continuous beam (10) when they are deflected past a fixed angle ; and
— means (15) for beam transfer in order to form the image (C') of the pupil (C) on the sample (21).

FIG.1

## FIG.2

Rang des impulsions.

1 ... R-1 R+1 ... 2R-1 2R+1 ... 3R-1 3R+1 ...

IMPULSIONS LASER

temps

$t_d$

IMPULSIONS DU FAISCEAU PRIMAIRE

$T_s$

temps

1 ... R-1 R R+1 ... 2R-1 2R 2R+1 ... 3R-1 3R 3R+1 ... Rang des impulsions

Impulsion sur la surface d'analyse.

Impulsion hors de la surface d'analyse.

## FIG.3

FIG.4

FIG.5

FIG.6

SIGNAL DE
DÉCLENCHEMENT

(a)

temps

IMPULSIONS
LASER

$t'_d$

$T_1$

(b)

temps

$V_{BB}$

$t''_d$

(c)

temps

IMPULSIONS
DU FAISCEAU
PRIMAIRE

$T_P$

(d)

1 ........ R-1 R R+1 ....... 2R-1 2R 2R+1 ........ 3R-1 3R

temps

Rang des
impulsions

$V_{BP}$

(e)

temps

EP 0 308 304 B1

12